## Europäisches Patentamt

## European Patent Office

## Office européen des brevets

(19)

(11) Numéro de publication: **0 087 841**
**B1**

(12)

# FASCICULE DE BREVET EUROPEEN

(45) Date de publication du fascicule du brevet:
21.05.86

(51) Int. Cl.⁴: **H 03 D 9/06,** H 01 L 29/60,
H 03 F 3/193

(21) Numéro de dépôt: 83200268.7

(22) Date de dépôt: 23.02.83

(54) Utilisation d'un transistor à effet de champ, du type à double grille et île ohmique intercalée, en vue de la réjection d'une bande de fréquences.

(30) Priorité: 03.03.82 FR 8203510

(43) Date de publication de la demande:
07.09.83 Bulletin 83/36

(45) Mention de la délivrance du brevet:
21.05.86 Bulletin 86/21

(84) Etats contractants désignés:
BE DE FR GB IT NL SE

(56) Documents cités:
BE - A - 682 210
FR - A - 746 126
FR - A - 2 302 592
US - A - 3 586 887
US - A - 3 986 060

1980 IEEE MTT-S INTERNATIONAL MICORWAVE SYMPOSIUM DIGEST, 1980, pages 363-366, New York, USA, D.R. DECKER et al.: "A monolithic GaAs- I.F. amplifier for integrated receiver application" MICROWAVES, no. 17, juillet 1981, pages 71-73, C. TSIRONIS et al.: DC characteristics aid dual-gate FET analysis"
1978 IEEE MTT-S INTERNATIONAL MICROWAVE SYMPOSIUM DIGEST, OTTAWA, 27-29 juin 1978, pages 300-302, New York, USA, S.C. CRIPPS et al.: "An X-band dual gate MESFET image rejection mixer"

(73) Titulaire: **Laboratoires d'Electronique et de Physique Appliquée L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **BE DE GB IT NL SE**

(72) Inventeur: **Tsironis, Christos, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

L'invention concerne un dispositif semiconducteur destiné à mélanger un signal de réception et un signal fourni par un oscillateur local, a amplifier le résultat de ce mélange et à rejeter une bande de fréquences donnée, er comprenant un transistor à effet de champ, du type à double grille et île ohmique intercalée entre les deux branches de ladite double grille, l'électrode de source étant reliée à la terre, le signal de réception étant appliquè sur la première branche de ladite double grille et le signal fourni par l'oscillateur local étant appliqué sur l'une ou l'autre branche de ladite double grille, alors que le signal en résultant est récupéré sur l'électrode de drain.

L'invention concerne le domaine des composants semiconducteurs, et plus précisément leur application dans le domaine des télécommunications hyperfréquences.

Le transistor à effet de champ, du type double grille et île ohmique intercalée, est connu de l'art antèrieur, notamment du brevet des Etats-Unis d'Amérique, de numéro 4,048,646, déposé le 25 Février 1976, sous priorité japonaise, pour le cessionnaire NIPPON ELECTRIC COMPANY, et également de la demande de brevet FR-A-2 302 592.

De travaux antérieurs, publiés par Van der Ziel et Takagi, dans ISEE Journal of Solid-State Circuits (corresp.), Vol. SC-4, Juin 1969, p. 170-172, dans un article intitulé "Improvement in the tetrode FET noise figure by neutralization and tuning", il étair connu de relier à l'extérieur l'électrode commune et intermédiaire d'un montage de deux transistors FET en cascade, en vue de diminuer le niveau de bruit.

Un tel montage de deux transistors FET en cascade est décrit par exemple dans le brevet des Etats-Unis d'Amérique de numéro 3,986,060. Plus particulièrement, la figure 9 de ce brevet décrit un dispositif dans lequel l'électrode commune et intermédiaire est reliée à la terre au travers d'un circuit resonnant de type LC.

Or, il est bien connu de l'art antérieur, par exemple de l'article paru dans IEEE Transactions on Microwave theory and techniques, vol. MTT 23, n-6, Juin 1975, intitulé "Performance of dual-gate GaAs MESFET's as gain-controlled low-noise amplifier and high-spéed modulators", par C.A. LIECHTI, qu'un transistor double grille est équivalent à deux transistors FET simple grille montés en cascade.

Mais, l'utilisation du circuit tel que decrit à la figure 9 de ce brevet US 3,986,060 est limitée aux amplificateurs, et ne s'etend pas aux mélangeurs.

Ainsi, alors que de nombreuses utilisations du transistor à effet de champ à double grille ont été envisagées, telles que par exemple en tant que mélangeur, modulateur, limiteur de puissance, multiplicateur de fréquence, mélangeur auto-ossillant, etc..., l'invention procède d'une nouvelle utilisation de ce moyen connu qu'est le transistor double grille à îLe ohmique, en combinaison avec des eléments inductifs et capacitifs, en vue de réaliser un circuit mélangeur-amplificateur propre à rejeter une bande de frequences donnée.

Il est connu de l'art antérieur d'utiliser un filtre passif pour la réjection de bandes au moyen d'éléments localises et l'on citera à titre d'exemple l'article "Monolithic low-noise amplifiers" par D. MAKI, R. ESFANDIARI et M. SIRACUSA, paru dans MICROWAVES, pages 103-106, d'Octobre 1981. L'inconvénient d'un tel filtre consiste essentiellement en l'introduction de pertes de l'ordre de 2 à 3 dB, à la fréquence du signal, alors que la réjection de bande est d'environ 25 à 30 dB.

Il est également connu des montages relativement complexes avec plusieurs transistors double grille et l'on citera pour exemple l'article "An X-band dual-gate MESFET Image rejection mixer" 1978 International Microwave Symposium Digest, p. 300-302.

L'invention vise à obtenir la réjection d'une bande de fréquences, sans perte, et d'une façon simple donc moins onéreuse, et une technologie intégrable.

Selon la presente invention, le dispositif semiconducteur est remarquable en ce qu'il comprend également un circuit résonnant, du type inductance et condensateur placés en série, connecté par une première extrémité à ladite île ohmique et par sa deuxième extrémité a la terre, alors qu'en outre des tensions de polarisation sont appliquées sur chaque branche de ladite double grille de telle sorte que la première partie du transistor, de l'électrode de source à l'île ohmique, est placée dans un état de saturation, et que la deuxième partie du transistor, de 1'île ohmique à l'électrode de drain, est placée dans un état de non saturation.

De cette manière, le dispositif semiconducteur est polarisé de telle sorte que la première partie du trsnsistor double grille (dite FET 1) agisse en tant que préamplificateur, slors que la deuxieme partie du transistor double grille (dite FET 2) agisse en tant que mélangeur. Ainsi, le filtre qui se compose d'un circuit résonnant série du type LC, connecté à l'île ohmique, est situé avant le mélangeur et évite ainsi un retour intempestif de fréquences parasites vers des éléments antérieurs et diminue le bruit en provenance de ces memes éléments. Cette distinction dans les parties (ou fonctions y attachées) d'un transistor double grille est maintenant bien connue et resulte de l'analyse des caractéristiques dudit transistor, et l'on pourra se reporter utilement à l'article "DC Characteristics aid dual-gate FET analysis" par C. TSIRONIS et R. MEIERER, dans MICROWAVES, pages 71-73, de Juillet 1981.

La description qui va suivre en regard des dessins annexés, donnés à titre non limitatif, permettra de mieux comprendre l'invention et d'en apprécier sa portée.

La figure 1 représente le schéma synoptique d'une tete de réception d'emissions télevisées distribuées par satellite artificiel.

La figure 2 représente les diverses bandes de fréquences présentes en divers points de ladite tête de réception.

La figure 3 représente un exemple de réalisation d'un filtre à coupure de bande, selon l'art antérieur.

La figure 4 représente le circuit amplificateur-mélangeur, à réjection sélective d'une bande de frequences, selon la présente invention.

La figure 5 représente les caractéristiques bidimensionnelles d'un tel circuit.

La figure 6 est un graphique illustrant les performances obtenues, au moyen de ce nouveau dispositif amplificateur-mélangeur.

La figure 7 représente une réalisation intégrée du circuit selon la figure précédente.

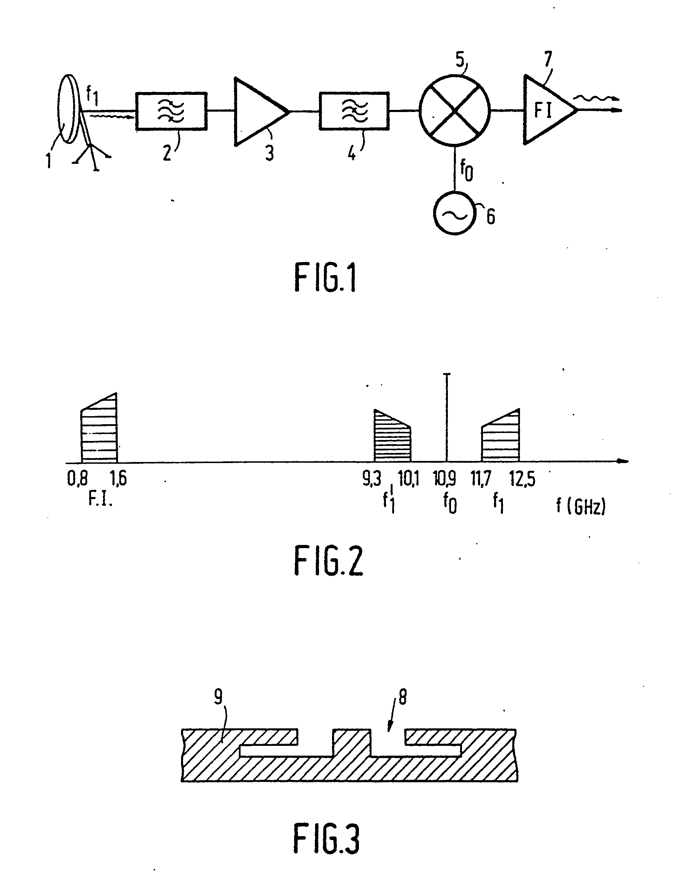

Le schéma synoptique selon la figure 1 représente le dispositif de réception et de transposition de fréquences d'un signal, tel que par exemple émis par un satellite artificiel et reçu à terre par l'antenne, de référence 1, constitué par un reflecteur parabolique, actuellement d'un diamètre voisin de un mètre, au foyer duquel se trouve la tête de réception proprement dite, qui se compose : d'un filtre passe bande 2, d'un préamplificateur 3 (par exemple 12 GHz), d'un filtre à réjection de fréquence 4 destiné a) à supprimer le bruit venant de l'antenne à la fréquence image, b) à supprimer les signaux à la fréquence image créés dans le dispositif mélangeur et c) à récupérer l'énergie des signaux fréquence image (image fantôme), et d'un mélangeur 5 à une autre entrée duquel est applique le signal pilote ($f_0$, par exemple 11 GHz) provenant d'un oscillateur local 6, tel qu'un transistor à effet de champ stabilisé en température au moyen de par exemple un résonateur diélectrique, et enfin d'un amplificateur 7 de fréquence intermédiaire (FI, par exemple 1 GHz).

Les fréquences présentes en divers points du dispositif de réception et de transposition, tel que décrit très généralement ci-dessus, sont représentées à la figure 2. Une bande de fréquences comprises sensiblement entre 11,7 et 12,5 GHz est typiquement utilisée pour les systèmes de télédistribution par satellites artificiels. Ce choix de la bande de fréquences résulte de la nécessité d'économiser la puissance à bord du satellite, et donc d'emettre de préférence dans les fenetres radioélectriques, donc sensiblement entre 0,5 et 50 GHz environ, l'attribution précise des bandes de fréquences étant décidée par un organisme international, le CCIR, dans le cadre de l'UIT.

Le signal émis par le satellite, dans cette bande de fréquences, est reçu à terre par une antenne individuelle ou communautaire et converti en un signal de plus basse fréquence en plusieurs étapes, de façon à pouvoir être accepté par un récepteur de télévision standard : un premier abaissement de fréquence (qui est seul concerné, dans le cadre du présent mémoire) à une fréquence intermédiaire de 1 GHz, d'autres ayant lieu ultérieurement jusqu'à la fréquence d'environ 130 MHz, à laquelle s'effectue une démodulation de fréquence et une modulation d'amplitude d'une fréquence porteuse qui sera appliquée au récepteur de télévision standard.

La fréquence de l'oscillateur local ($f_0$ - 10,9 GHz) est représentée par un trait vertical et la fréquence intermédiaire qui résulte de l'abaissement de fréquence par mélange soustractif est représentée par la bande comprise sensiblement entre 0,8 et 1,6 GHz. La bande de fréquences parasites (bande image), qui est représentée dans cette figure en noir, est comprise entre 9,3 et 10,1 GHz, dans cet exemple chiffré, et résulte de l'abaissement de fréquences entre des harmoniques de l'oscillation pilote (en l'espèce $2 f_{0 - 2}$ 1,8 GHz) et de la bande de fréquences reçue (11,7 - 12,5 GHz). Cette bande de fréquences parasites est très genante, car, étant générée dans le mélangeur, si elle se dirige vers les éléments antérieurs, elle peut en perturber le fonctionnement. D'autre part, le bruit et tous les signaux parasites reçus par l'antenne et amplifiés par le préamplificateur dans la bande de fréquences image sont aussi abaissés dans la bande de frequences intermédiaire et augmentent le facteur de bruit ou sont genants à la reception. Il est alors nécessaire de disposer un filtre à coupure de bande (référencé 4 sur la figure 1) qui fonctionne par absorption ou reflexion de l'énergie transmise. Dans le cas du fonctionnement en réflexion, l'énergie générée dans le mélangeur à la fréquence image ($2 f_0 - f_1$) peut aussi bien être récupérée en améliorant de cette manière le gain de conversion du mélangeur.

Un exemple de réalisation selon l'art antérieur de ce filtre à coupure de bande est représenté à la figure 3, sous la forme d'échancrures en "ergots" ou "éperons" 8 réalisées dans une ligne microruban 9 (en anglo-saxon : "spur-line filter"). Un tel filtre hyperfréquence à coupure de bande est connu de l'article paru dans Microwaves, Optics and Acoustics, de Novembre 1977, Vol.1, n-6, sous le titre "Design of microstrip spur-line band stop filters" par R.N. BATES. Selon cette figure 3, une bande conductrice 9 est munie d'entailles dites en éperons 8, car constituées de deux entailles symétriques en opposition, chacune constituée d'une première fente rectiligne perpendiculaire au bord de ladite bande conductrice, et d'une seconde fente rectiligne parallèle au bord de la bande et située au milieu de celle-ci. La longueur des portions de la bande conductrice isolées par lesdites entailles définit la fréquence centrale de la bande de fréquences rejetée et correspond normalement à $1 = 3/4 \lambda$ où $\lambda$ est la longueur d'onde dans le milieu diélectrique du substrat.

D'autres types de filtres peuvent être utilisés, ainsi celui précédemment cité, réalisé au moyen d'eléments localisés (MICROWAVES, Octobre 1981), mais l'inconvénient principal des réalisations antérieures résulte de ce qu'ils sont situés en série sur les lignes conductrices hyperfréquences, et qu'ils introduisent alors des pertes de l'ordre de 2 à 3 dB à la fréquence du signal (12 GHz), alors que la réjection de bande s'effectue de façon satisfaisante, avec un taux d'environ 25 à 30 dB.

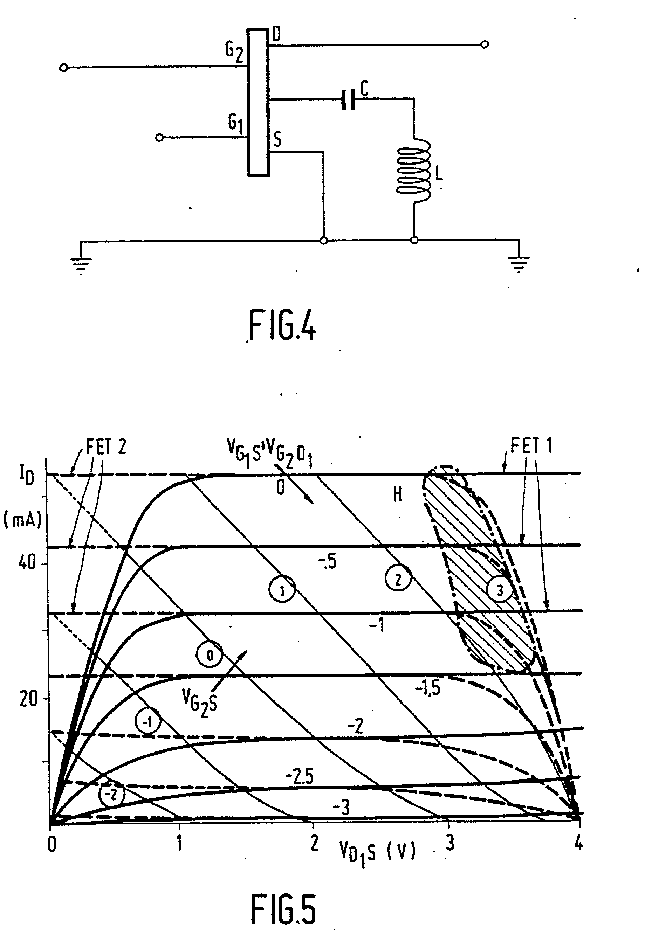

La figure 4 décrit la réalisation, selon la présente invention, d'un circuit amplificateur-mélangeur, à réjection sélective d'une bande de frequences. Le composant utilisé est un transistor à effet de champ, du type à double-grille et à île ohmique intercalée entre les deux branches de ladite double-grille.

Pour une utilisation correcte de ce composant en tant que mélangeur, l'électrode de source (S) est reliée à la terre, les signaux à mélanger sont appliques sur les electrodes de grille ($G_1$ et $G_2$) et le signal mélangé est récupéré sur l'electrodede drain (D). La réjection de fréquences est obtenue alors, conformément à la presente invention, en connectant par une de ses extrémités, un circuit resonnant série, du type inductance-condensateur (LC) à l'île ohmique dudit transistor à effet de champ, et par l'autre extrémite, à la terre.

Cependant, selon ce montage, lorsque le signal reçu par l'antenne est appliqué sur la première électrode de grille ($G_1$) et que le signal fourni par l'oscillateur local est appliqué sur l'une ou l'autre des électrodes de grille ($G_1$ ou $G_2$), alors le mélange s'effectue dans des conditions normales d'utilisation, dans la première partie (FET 1) dudit transistor. Dans ce cas, le montage ne convient pas puisque le filtre est situé après le mélangeur et non avant.

En vue d'obtenir un montage convenable, il faut que le filtre soit situé avant le mélangeur, c'est-à-dire qu'en l'espèce, le mélange s'effectue dans la deuxième partie (FET 2) dudit transistor.

Conformément aux dispositions de la présente invention, un tel fonctionnement s'obtient en polarisant le dispositif, ainsi qu'il ressort de l'analyse des courbes caractéristiques bidimensionelles dudit transistor, telles que décrites dans l'article précité (MICROWAVES, Juillet 1981, TSIRONIS et MEIERER), et représentées en l'espèce à la figure 5, de façon à se situer dans la zone hachurée H, pour lesquelles la première partie (FET 1) du composant est placée dans un état de saturation, et la deuxième partie (FET 2) est placée dans un état de non saturation.

Avec un composant en arséniure de gallium GaAs, spécialement conçu par la Demanderesse, et présentant les caractéristiques suivantes: largeur de grille $G_1$ ($W_1$-1 μm), largeur de grille $G_2$ ($W_2$ - 1 μm) et espacement drain-source (W - 6-8 μ), les conditions de fonctionnement dans la zone hachurée H ont été obtenues simplement avec les polarisations suivantes:

$V_{DS}$ - 4 volts

FIG1/25

alors que le courant de drain atteignait des valeurs comprises entre 20 et 50 mA.

De cette manière, le fonctionnement du dispositif est convenable, et la réjection sélective de la bande de fréquences est supérieure à 30 dB. La largeur de la bande de fréquences rejetée est réduite à une valeur de 100 MHz, par l'utilisation de pièces d'accord (tuners) de fréquence intermédiaire (1 GHz) coaxiales d'un facteur de qualité Q élevé.

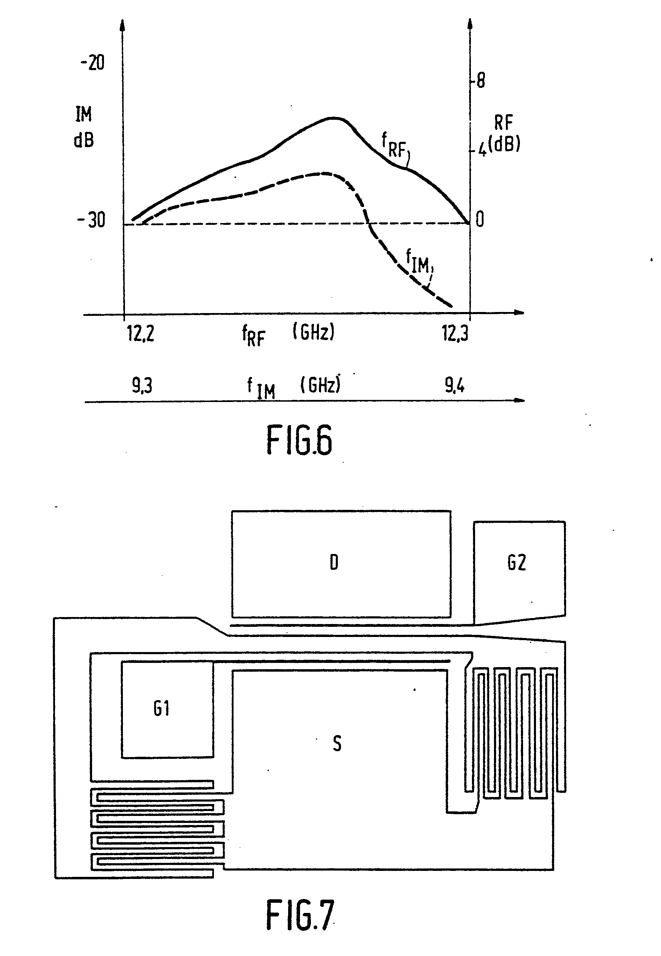

La figure 6 est un graphique illustrant les performances obtenues au moyen de ce nouveau dispositif. La première courbe en trait plein représente les résultats obtenus à la fréquence du signal, avec en abscisses la fréquence comprise entre 12,2 et 12,3 GHz- et en ordonnées l'amplification -comprise entre 3 et 6 dB-. La deuxième courbe en traits pointillés représente les résultats obtenus à la frequence d'image, avec en abscisses la frequence -comprise entre 9,3 et 9,4 GHz- et en ordonnées l'atténuation -comprise entre -25 et -35 dB-.

Enfin, la figure 7 représente une réalisation intégrée de ce nouveau dispositif, dans une vue supérieure. Le composant actif est élaboré sur un mésa obtenu par croissance épitaxiale en phase vapeur et décapage, selon une technologie connue d'autoalignement. Les éléments passifs, inductances et condensateurs, sont obtenus par une structure interdigitée, qui peut être par exemple fractionnée en deux parties distinctes dont les valeurs ($L_1$, $C_1$ et $L_2$, $C_2$) légèrement differentes permettent d'élargir la bande de fréquences rejetée.

Ces éléments peuvent également être obtenus sur la surface d'un dispositif semiconducteur intégré, par des extension des dépôts métalliques effectués dans les étapes du procédé d'autoalignement, selon un cheminement en spirale (inductance), et par un dépôt supplémentaire métallique, une couche isolante diélectrique étant entre temps déposée, selon une configuration en pont (capacitance).

Il est évident pour l'homme de l'art que de nombreuses variantes de réalisation de la présente invention peuvent être obtenues, par transposition de techniques antérieures connues, sans pour cela qu'il soit fait oeuvre d'esprit, et donc sans sortir du cadre de la présente invention tel que défini par les revendications ci-après annexées.

**Revendication**

1. Dispositif semiconducteur destiné à mélanger un signal de réception et un signal fourni par un oscillateur local, a amplifier le résultat de ce mélange et à rejeter une bande de fréquence donnée, et comprenant un transistor à effet de champ, du type à double grille et île ohmique intercalée entre les deux branches de ladite double grille, l'électrode de source (S) étant reliée à la terre, le signal de réception étant appliqué sur la première branche de ladite double grille ($G_1$) et le signal fourni par l'oscillateur local étant appliqué sur l'une ou l'autre branche de ladite double grille ($G_1$ ou $G_2$), alors que le signal en résultant est récupéré sur l'électrode de drain (D), caractérisé en ce qu'il comprend également un circuit résonnant, du type inductance et condensateur placés en série, connecté par une première extrémité à ladite île ohmique et par sa deuxième extrémité à la terre, alors qu'en outre des tensions de polarisation sont appliquées sur chaque branche de ladite double grille, de telle sorte que la première partie du transistor, de l'électrode de source à l'île ohmique, est placée dans un état de saturation, et que la deuxième partie du transistor, de l'île ohmique à l'electrode de drain, est placée dans un état de non saturation.

**Patentanspruch**

Halbleiteranordnung zum Mischen eines Empfangssignals und eines Signals, das von einem Ortsoszillator (6) geliefert wird zum Verstärken des Ergebnisses dieses Mischverfahrens und zum Austasten eines bestimmten Frequenzbandes, wobei diese Halbleiteranordnung einen Doppel-Gate-Feldeffekttransistor aufweist mit einer zwischenliegenden ohmschen Insel zwischen den zwei Transistorhälften des genannten Doppel-Gate-Feldeffekttransistors, wobei die Source-Elektrode (S) an Erde gelegt ist, wobei das Empfangssignal dem ersten Gate ($G_1$) des genannten Ortsoszillator (6) gelieferte Signal einem oder dem anderen Gate ($G_1$ oder $G_2$) des genannten Doppel-Gate-Feldeffekttransistors zugeführt wird, wobei das resultierende Signal an der Drain-Elektrode (D) wiedergewonnen wird, dadurch gekennzeichnet, dass die Halbleiteranordnung weiterhin einen Resonanzkreis aufweist von dem Typ mit einer Induktanz und einem Kondensator, die in Reihe über ein erstes Ende mit der genannten ohmschen Insel und über ein zweites Ende mit Erde verbunden sind, während jeder Elektrode des genannten Doppel-Gate-Feldeffekttransistors Polarisierungsspannungen zugeführt werden, so dass der erste Teil des Transistors, der sich von der Source-Elektrode zu der ohmschen Insel erstreckt, in einen Sättigungszustand gebracht wird und dass der zweite Teil des Transistors, der sich von der ohmschen Insel zu der Drain-Elektrode erstreckt, in einen nicht gesättigen Zustand gebracht wird.

**Claim**

A semiconductor device for mixing a reception signal and a signal supplied by a local oscillator, for amplifying the result of this mixing process and for rejecting a given frequency band, which includes a dual gate field effect transistor having an intermediate ohmic island between the two transistor halves of said dual gate field effect transistor, the source electrode (S) being connected to earth, the reception signal being applied to the first gate ($G_1$) of said dual gate field effect transistor and the signal supplied by the local oscillator being applied to one or the other gate ($G_1$ or $G_2$) of said dual gate field effect transistor, while the resulting signal is recovered at the drain electrode (D), characterized in that it further incorporates a resonant circuit of the type comprising an inductance and a capacitor arranged in series-combination connected through a first end to said ohmic island and through its second end to earth, while polarization voltages are applied to each electrode of said dual gate field effect transistor so that the first part of the transistor extending from the source electrode to the ohmic island is brought into a state of saturation and that the second part of the transistor extending from the ohmic island to the drain electrode is brought into a state of non-saturation.

0 087 841

FIG.1

FIG.2

FIG.3

FIG.4

FIG.5

FIG.6

FIG.7